(19) Europäisches Patentamt
European Patent Office
Office européen des brevets

(11) **EP 4 149 211 B1**

(12) **EUROPEAN PATENT SPECIFICATION**

(45) Date of publication and mention
of the grant of the patent:
**07.05.2025 Bulletin 2025/19**

(21) Application number: **22159338.7**

(22) Date of filing: **01.03.2022**

(51) International Patent Classification (IPC):
*H05B 45/32* (2020.01)     *G01S 7/484* (2006.01)
*H01S 5/042* (2006.01)     *G01S 17/10* (2020.01)
*H01S 5/062* (2006.01)     *H01S 5/183* (2006.01)

(52) Cooperative Patent Classification (CPC):
**H05B 45/32; G01S 7/484; G01S 17/10;
H01S 5/0428;** H01S 5/06216; H01S 5/183

(54) **LIGHT EMITTING DEVICE AND DETECTION APPARATUS**

LICHTEMITTIERENDE VORRICHTUNG UND DETEKTIONSEINRICHTUNG

DISPOSITIF ÉLECTROLUMINESCENT ET APPAREIL D'ÉCLAIRAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **09.09.2021 JP 2021146777**

(43) Date of publication of application:
**15.03.2023 Bulletin 2023/11**

(73) Proprietor: **FUJIFILM Business Innovation Corp.
Minato-ku
Tokyo (JP)**

(72) Inventor: **IGUCHI, Daisuke
Ebina-shi (JP)**

(74) Representative: **Becker, Eberhard
Becker Kurig & Partner
Patentanwälte mbB
Bavariastraße 7
80336 München (DE)**

(56) References cited:
**JP-A- 2009 260 030      JP-A- 2021 025 778
US-A- 5 933 224      US-A1- 2015 285 625
US-A1- 2017 070 029      US-A1- 2017 276 771
US-A1- 2021 021 098      US-A1- 2022 271 502**

• **TEXAS INSTRUMENTS: "TIDA-01573 -
Nanosecond Laser Driver Reference Design for
LiDAR", 1 February 2018 (2018-02-01), pages 1 -
21, XP093123859, Retrieved from the Internet
<URL:https://www.ti.com/lit/ug/tidue52/tidue52.
pdf?ts=1660837728571> [retrieved on 20240125]**

**Description**

BACKGROUND OF THE INVENTION

(i) Field of the Invention

The present invention relates to a detection apparatus including a light emitting device.

(ii) Description of Related Art

JP2020-188239A describes that in a light emitting device, a general-purpose (normal) capacitor is further connected to a series circuit of a light emitting element and a transistor.

JP 2009 260030 A discloses a light source device that includes a laser diode driving device and a laser diode. The laser diode driving device has an input electrode and an output electrode, a current driving unit supplying a pulsed driving current that repeats a high level and a low level of current to the laser diode, a first field effect transistor connected in parallel to the laser diode to turn on/off an electrical connection between the input electrode and the output electrode, and the connection to the first field effect transistor.

US 2021/021098 A1 discloses a resonant H-bridge laser driver circuit topology is described that can achieve high current levels at narrow pulse widths while using smaller transistor sizes.

US 2017/276771 A1 discloses a laser radar device that detects reflected light of light emitted by a laser device, which is the source of electromagnetic waves, to measure the location of an object that has reflected the electromagnetic waves.

US 2017/070029 A1 discloses a method for controlling a laser radar device including: closing a first switch configured to open or close a power supply circuit including a laser element; applying a voltage in a forward direction to the laser element; illuminating an object with an electromagnetic wave emitted from the laser element; applying, to the laser element, a voltage in a reverse direction that is opposite to the forward direction when the first switch is opened; detecting a reflected wave from the object; and measuring a location of the object.

SUMMARY OF THE INVENTION

There is a technique for causing the light emitting element to emit light by supplying a current to the light emitting element by an electric accumulator that applies a voltage to a power supply and accumulates electric charge. Further, in a resonant circuit in which an electric accumulator is provided and which generates resonance, a current generated by the resonance may be supplied to the light emitting element. In such a case, in a configuration in which the circuit from the power supply to the resonant circuit is constantly conductive, the electric charge may be supplied from the power supply to the resonant circuit even in a case where the current in the resonant circuit is supplied to the light emitting element, and resonance in the resonant circuit may be attenuated.

An object of the present invention is to suppress attenuation of resonance in the resonant circuit as compared with a configuration in which the circuit from the power supply to the resonant circuit is being constantly conductive.

The present invention is provided by the appended claims. The following disclosure serves a better understanding of the present invention.

According to a first aspect of the present disclosure, there is provided a light emitting device including: a resonant circuit that is provided with an electric accumulator accumulating electric charge and generates resonance; a light emitting element that emits light in a case where a current in the resonant circuit is supplied; and a first switching unit that is connected to a circuit between a power supply that supplies electric charge to the electric accumulator and the resonant circuit, and switches between a conduction state in which a circuit from the power supply to the resonant circuit is conductive and a non-conduction state in which the circuit is not conductive.

According to a second aspect of the present disclosure, in the light emitting device of the first aspect, the first switching unit may be in the non-conduction state in a case where the electric accumulator supplies a current to the light emitting element.

According to a third aspect of the present disclosure, the light emitting device of the second aspect may further include: a second switching unit that switches between a conduction state in which the resonant circuit is conductive and a non-conduction state in which the resonant circuit is not conductive; and a switching control unit that switches the first switching unit to the non-conduction state before the second switching unit is switched to the conduction state in a case where the first switching unit is in the conduction state and the second switching unit is in the non-conduction state.

According to a fourth aspect of the present disclosure, in the light emitting device of the first aspect, the first switching unit may be in the conduction state in a case where the electric accumulator does not supply a current to the light emitting element.

According to a fifth aspect of the present disclosure, the light emitting device of the fourth aspect may further include: a second switching unit that switches between a conduction state in which the resonant circuit is conductive and a non-conduction state in which the resonant circuit is not conductive; and a switching control unit that switches the first switching unit to the conduction state after the second switching unit is switched to the non-conduction state in a case where the first switching unit is in the non-conduction state and the second switching unit is in the conduction state.

According to a sixth aspect of the present disclosure, the light emitting device of the first aspect may further include: a second switching unit that switches between a conduction state in which the resonant circuit is conductive and a non-conduction state in which the resonant circuit is not conductive; and a switching control unit that switches the first switching unit between the conduction state and the non-conduction state, in which a time at which the second switching unit becomes the conduction state and a time at which the second switching unit becomes the non-conduction state are predetermined, and a time at which the switching control unit puts the first switching unit into the non-conduction state is determined, depending on the time at which the second switching unit becomes the conduction state, and a time at which the switching control unit puts the first switching unit into the conduction state is determined, depending on the time at which the second switching unit becomes the non-conduction state.

According to a seventh aspect of the present disclosure, in the light emitting device of the first aspect, in which in an electric path from the power supply to the resonant circuit, a lower limit value of an electric resistance necessary to suppress attenuation of the resonance may be a first electric resistance, and an electric resistance of the electric path from the power supply to the resonant circuit in a case where the first switching unit is in the conduction state may be a second electric resistance smaller than the first electric resistance.

According to an eighth aspect of the present disclosure, in the light emitting device of the seventh aspect, in a case where the electric resistance of the electric path from the power supply to the resonant circuit is the first electric resistance, a time period necessary to supply a first amount of electric charge from the power supply to the electric accumulator may be a first time period, the first amount of electric charge may be an amount of electric charge necessary to be accumulated in the electric accumulator in order for the light emitting element to emit light by causing the electric accumulator to supply a current to the light emitting element, in a case where light emission of the light emitting element is completed, the first amount of electric charge may be supplied from the power supply to the electric accumulator via the first switching unit in the conduction state, the light emitting element may re-emit light in a case where a current in the resonant circuit is supplied from the electric accumulator, and in a case where the electric resistance of the electric path from the power supply to the resonant circuit is the second electric resistance, a time period from an end of the light emission of the light emitting element to the light re-emission of the light emitting element may be shorter than the first time period.

According to a ninth aspect of the present disclosure, there is provided a detection apparatus including: the light emitting device according to claim 1; a light receiving unit that receives light based on irradiation of a target object with light emitted from the light emitting device; and a detection unit that detects a distance to the target object on the basis of light reception of the light receiving unit, in which the first switching unit switches to the conduction state, in a case where a current necessary for light emission of the light emitting element is supplied from the electric accumulator to the light emitting element in the non-conduction state, the electric charge necessary for supply of a current for causing the light emitting element to emit light is accumulated in the electric accumulator, after a current necessary for light emission of the light emitting element is supplied from the electric accumulator until the light receiving unit receives light on the basis of the light emission, and a detection target includes a distance of 10 m as a distance to the target object.

According to a tenth aspect of the present disclosure, there is provided a detection apparatus including: a resonant circuit that is provided with an electric accumulator accumulating electric charge and generates resonance; a light emitting element that emits light in a case where a current in the resonant circuit is supplied; a first switching unit that is connected to an electric path between a power supply that applies a voltage to the electric accumulator and the resonant circuit, and switches between a conduction state in which a circuit from the power supply to the resonant circuit is conductive and a non-conduction state in which the circuit is not conductive; a light receiving unit that receives light based on irradiation of a target object with light emitted from the light emitting element; and a detection unit that detects a distance to the target object on the basis of light reception of the light receiving unit.

According to an eleventh aspect of the present disclosure, the detection apparatus of the tenth aspect may further include: a second switching unit that switches between a conduction state in which the resonant circuit is conductive and a non-conduction state in which the resonant circuit is not conductive, in which a time period from a time at which the second switching unit becomes the non-conduction state to a time at which the second switching unit becomes the conduction state is determined in accordance with the distance to the target object that is set as a detection target in the detection apparatus.

According to the first aspect of the present invention, it is possible to suppress attenuation of resonance in the resonant circuit as compared with the configuration in which the circuit from the power supply to the resonant circuit is being constantly conductive.

According to the second aspect of the present invention, the attenuation of resonance in the resonant circuit can be suppressed as compared with the configuration in which the first switching unit is in the conduction state in a case where the electric accumulator supplies the current to the light emitting element.

According to the third aspect of the present invention, the attenuation of resonance in the resonant circuit can be suppressed as compared with the configuration in which the first switching unit is switched to the non-conduction state after the second switching unit is switched to the conduction state.

According to the fourth aspect of the present invention, the time period necessary to charge the electric accumulator can be shortened as compared with the configuration in which the first switching unit is in the non-conduction state in a case where the electric accumulator does not supply a current to the light emitting element.

According to the fifth aspect of the present invention, the attenuation of resonance in the resonant circuit can be suppressed as compared with the configuration in which the first switching unit is switched to the conduction state before the second switching unit is switched to the non-conduction state.

According to the sixth aspect of the present invention, the state of the first switching unit can be switched in accordance with the state of the second switching unit.

According to the seventh aspect of the present invention, the time period necessary to charge the electric accumulator can be shortened as compared with the configuration in which the resistor necessary to suppress the attenuation of resonance is connected to the electric path from the power supply to the resonant circuit.

According to the eighth aspect of the present invention, the frequency with which the light emitting element emits light can be increased as compared with the configuration in which the electric resistance of the electric path from the power supply to the resonant circuit is equal to or greater than the first electric resistance.

According to the ninth aspect of the present invention, in a detection apparatus including a distance of 10 m as a distance to a target object as a detection target, the light emitting element can be made to re-emit light without providing the time period necessary to charge the electric accumulator after the light receiving unit receives light.

According to the tenth aspect of the present invention, the attenuation of resonance in the resonant circuit can be suppressed as compared with the configuration in which the circuit from the power supply to the resonant circuit is being constantly conductive.

According to the eleventh aspect of the present invention, as compared with the configuration in which the time period from the non-conduction state to the conduction state of the second switching unit is constant regardless of the distance as a detection target of the detection apparatus, it is easy for the detection unit to identify which of the light received by the light receiving unit is based on the light emitted from the light emitting device at which time.

BRIEF DESCRIPTION OF THE DRAWINGS

Exemplary embodiment(s) of the present invention will be described in detail based on the following figures, wherein:

Fig. 1 is a diagram showing a configuration example of a detection apparatus according to the present exemplary embodiment;

Fig. 2 is a diagram showing an electronic circuit of a light emitting device;

Fig. 3 is a diagram showing a relationship between a timing at which the state of the transistor is switched and a timing at which the state of the switching unit is switched;

Fig. 4 is a diagram showing an operation in which a detection apparatus detects a distance to a target object;

Fig. 5 is a diagram showing a comparative example; and

Fig. 6A is a diagram showing a relationship between the time period and change in amount of electric charge of a capacitor due to an operation of a light emitting device in a comparative example, and Fig. 6B is a diagram showing a relationship between the time period and change in amount of electric charge of a capacitor due to an operation of a light emitting device in the present exemplary embodiment.

DETAILED DESCRIPTION OF THE INVENTION

Hereinafter, exemplary embodiments of the present invention will be described in detail with reference to the accompanying drawings.

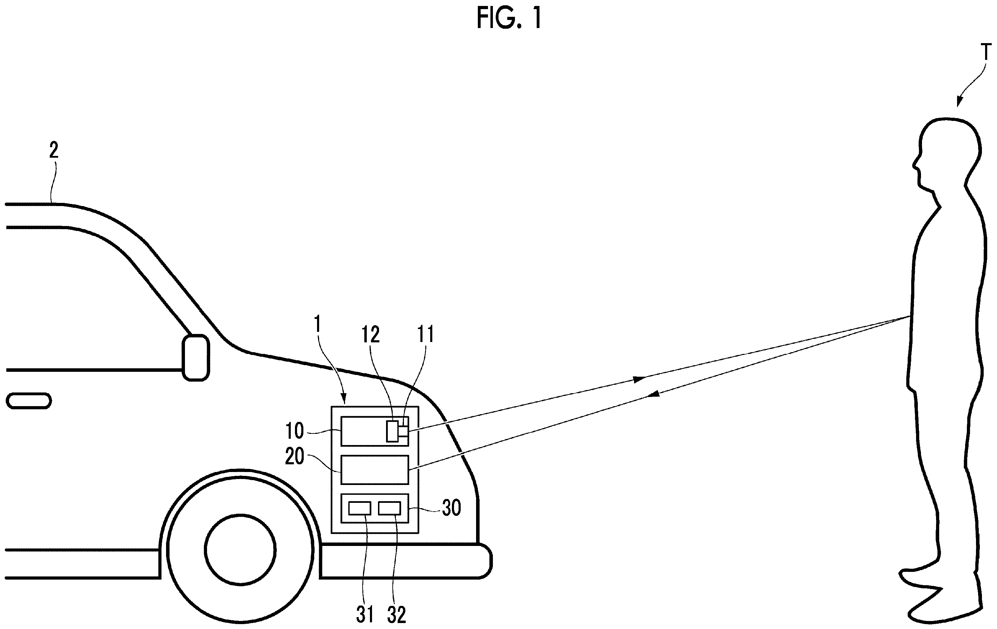

Fig. 1 is a diagram showing a configuration example of a detection apparatus 1 according to the present exemplary embodiment. The detection apparatus 1 is a device which detects a distance from the detection apparatus 1 to an object. The object as a target to which the detection apparatus 1 detects the distance is hereinafter referred to as a target object T. In the present exemplary embodiment, the light detection and ranging (LiDAR) is used as a method for the detection apparatus 1 to detect a distance to the target object T. The LiDAR is to measure the distance to the target object T by detecting light. The LiDAR includes a condensed type LiDAR in which light is emitted in a condensed range and a diffused type LiDAR in which light is diffused and emitted.

Further, in the LiDAR, the time of flight (TOF) is used. The TOF is to measure the distance to the target object T on the basis of a time period in which light travels. The TOF includes the indirect time of flight (iTOF) and the direct time of flight (dTOF). The iTOF is a method of measuring the distance to the target object T on the basis of a difference between a phase of the emitted light and a phase of the received light. Further, the dTOF is a method of measuring the distance to the target object T on the basis of a time period from emission of the light to light reception. The detection apparatus 1 of the present exemplary embodiment detects the distance to the target object T by the dTOF. However, the detection apparatus 1 may detect the distance to the target object T by the iTOF.

The detection apparatus 1 of the present exemplary embodiment includes a light emitting device 10, a light receiving unit 20, and a detection unit 30.

The light emitting device 10 is a device which emits light. Examples of the light emitting device 10 include a vertical cavity surface emitting laser (VCSEL). The VCSEL is a laser which emits light in a direction perpendicular to a surface of a substrate. Further, the light emitting device 10 of the present exemplary embodiment generates a current by resonance, and emits pulsed light by the generated current. The light emitting device 10 includes a light emitting element 11 and a substrate 12.

The light emitting element 11 is an element which emits light in a case where a current is supplied. The light emitting element 11 emits light in a direction perpendicular to a surface of the substrate 12.

The substrate 12 is a substrate on which a part of the resonant circuit is provided. A resonant circuit is an electronic circuit in which resonance occurs.

The light receiving unit 20 as an example of the light receiving unit receives light based on irradiation of the target object T with the light emitted from the light emitting device 10. Further, in a case where the light receiving unit 20 receives light, electric charge is generated. Examples of the light based on the irradiation of the target object T with the light emitted from the light emitting device 10 include light emitted from the light emitting device 10 and reflected by the target object T, and light scattered by irradiating the target object T with the light emitted from the light emitting device 10. The light emitted from the light emitting device 10 may be referred to as emitted light below. Further, the light emitted from the light emitting device 10 and reflected by the target object T is hereinafter referred to as reflected light. Further, the light scattered by irradiating the target object T with the light emitted from the light emitting device 10 is hereinafter referred to as scattered light.

Examples of the light receiving unit 20 include an optical sensor which detects light. Further, examples of the optical sensor include semiconductors such as a single photon avalanche diode (SPAD).

The detection unit 30 as an example of the detection unit detects the distance from the detection apparatus 1 to the target object T, on the basis of the light received by the light receiving unit 20. The detection unit 30 has a time measurement unit 31 and a measurement unit 32.

The time measurement unit 31 measures a time period.

The measurement unit 32 acquires information indicating the time period from the light emission from the light emitting device 10 to the generation of electric charge from the light receiving unit 20 from the time measurement unit 31. Then, from the acquired information, the distance from the detection apparatus 1 to the target object T is measured. More specifically, the measurement unit 32 measures the distance from the detection apparatus 1 to the target object T from Expression (1).

$$L = (c \times t) / 2 \qquad \cdots (1)$$

In Expression (1), L is the distance from the detection apparatus 1 to the target object T. Further, c is a speed of light. Further, t is a time period from emission of light from the light emitting device 10 to generation of electric charge by the light receiving unit 20. In addition, the measurement unit 32 measures the distance from the detection apparatus 1 to the target object T by setting a time period from emission of light from the light emitting device 10 to generation of electric charge by the light receiving unit 20 to a time period from when emission of light from the light emitting device 10 to light reception of the light receiving unit 20.

The detection apparatus 1 is provided in a movable body 2 which is traveling. In the illustrated example, an automobile is shown as the movable body 2. The movable body 2 is not limited to the illustrated example. The movable body 2 may be, for example, a drone, a train, a ship, an airplane, or the like. Further, the movable body 2 may be a computer carried by the user of the detection apparatus 1.

Further, in the illustrated example, a human being is shown as the target object T, but the target object T is not limited to the human being. The target object T may be any object as long as the object reflects the light emitted from the light emitting device 10 or scatters the light by being irradiated with the light emitted from the light emitting device 10.

Further, the detection apparatus 1 of the present invention sets the distance to the target object T as a detection target from a plurality of stages. Then, the detection apparatus 1 includes a distance of 10 m as the distance to the target object T as a detection target.

Next, a configuration of the light emitting device 10 will be described.

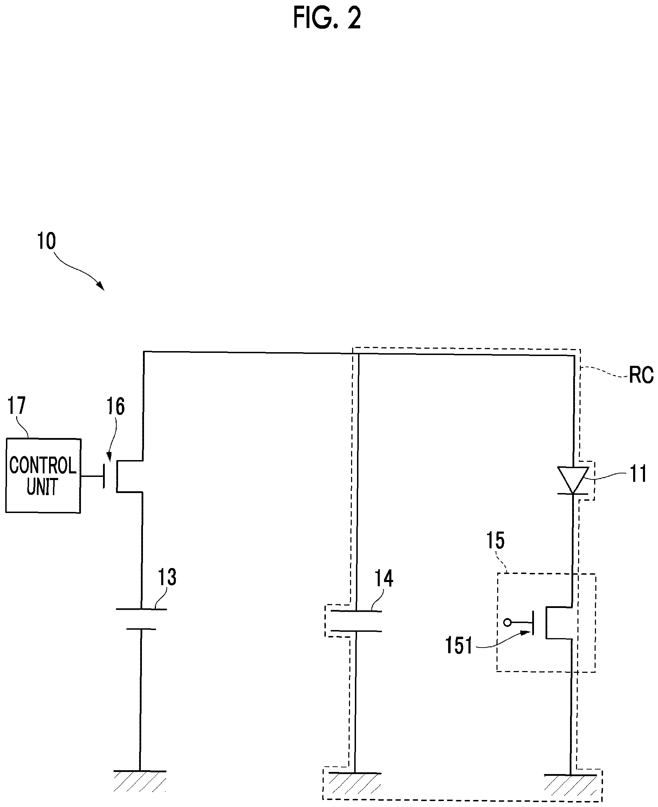

Fig. 2 is a diagram showing an electronic circuit of the light emitting device 10.

As shown in Fig. 2, the electronic circuit of the light emitting device 10 is provided with a resonant circuit RC. The resonant circuit RC of the present exemplary embodiment is provided with a light emitting element 11. In a case where the current in the resonant circuit RC is supplied to the light emitting element 11, the light emitting element 11 emits light.

Further, the light emitting device 10 is provided with a power supply 13, a capacitor 14, an operation unit 15, a switching unit 16, and a control unit 17.

The power supply 13 supplies electric charge to the capacitor 14.

The capacitor 14 as an example of the electric accumulator is an element which accumulates electric charge. Further, the capacitor 14 supplies a current to the light emitting element 11 by discharging the accumulated electric charge. The capacitor 14 may be provided as a part of a plurality of layers constituting the substrate 12, or may be provided as a component which is separate from the substrate 12. In the present exemplary embodiment, a capacitance of the capacitor 14 is determined such that a current necessary for the light emitting element 11 to emit light once is accumulated in the capacitor 14.

The operation unit 15 is an integrated circuit (IC) which operates the light emitting element 11. The operation unit 15 is provided with a transistor 151.

The transistor 151 as an example of a second switching unit is an electronic switch which switches between a state in which the resonant circuit RC is conductive and a state in which the resonant circuit RC is not conductive, depending on the applied voltage. In a case where a voltage equal to or greater than a predetermined value is not applied to the transistor 151, the transistor 151 is in an OFF state. In such a case, since a circuit to which the transistor 151 is connected is cutoff and the resonant circuit RC is being not conductive, no current is supplied to the light emitting element 11. Further, in a case where a voltage equal to or greater than a predetermined value is applied to the transistor 151, the transistor 151 is in an ON state. In such a case, since the circuit to which the transistor 151 is connected is connected and the resonant circuit RC is in a conduction state, the circuit is in a resonance state in the resonant circuit and the generated current is supplied to the light emitting element 11. In the present exemplary embodiment, an application unit (not shown) for applying a voltage to the transistor 151 is provided in the operation unit 15, and the application unit controls the transistor 151 to switch the transistor 151 into either one of an ON state and an OFF state.

Further, in the following, a state in which the transistor 151 conducts the resonant circuit RC may be referred to as a conduction state. Further, a state in which the transistor 151 does not conduct the resonant circuit RC may be referred to as a non-conduction state. The conduction state of the transistor 151 is a state in which the transistor 151 is ON. Further, the non-conduction state of the transistor 151 is a state in which the transistor 151 is OFF.

The switching unit 16 as an example of the first switching unit is a switch which switches between a state in which a circuit from the power supply 13 to the resonant circuit RC is conductive and a state in which the circuit is not conductive. In the present exemplary embodiment, a transistor is used as the switching unit 16. The switching unit 16 is connected to the circuit between the power supply 13 and the resonant circuit RC. Then, the switching unit 16 switches between a state in which the circuit from the power supply 13 to the resonant circuit RC is conductive and a state in which the circuit is not conductive, depending on the applied voltage.

In a case where a voltage equal to or greater than a predetermined value is applied to the switching unit 16, the switching unit 16 is in an ON state. In such a case, the circuit to which the switching unit 16 is connected is connected, and the circuit from the power supply 13 to the resonant circuit RC is in a conduction state. Therefore, the capacitor 14 is charged by supplying the electric charge from the power supply 13 to the capacitor 14.

Further, in a case where a voltage equal to or greater than a predetermined value is not applied to the switching unit 16, the switching unit 16 is in an OFF state. In such a case, the circuit to which the switching unit 16 is connected is cutoff, and the circuit from the power supply 13 to the resonant circuit RC is being not conductive. At this time, no electric charge is supplied from the power supply 13 to the capacitor 14.

In the following, a state in which the switching unit 16 conducts a circuit from the power supply 13 to the resonant circuit RC may be referred to as a conduction state. Further, a state in which the switching unit 16 does not conduct the circuit from the power supply 13 to the resonant circuit RC may be referred to as a non-conduction state. The conduction state of the switching unit 16 is a state in which the switching unit 16 is ON. Further, the non-conduction state of the switching unit 16 is a state in which the switching unit 16 is OFF.

The control unit 17 as an example of the switching control unit switches between the conduction state and the non-conduction state of the switching unit 16. More specifically, the control unit 17 switches between a conduction state and a non-conduction state of the switching unit 16 by switching whether or not to apply a voltage equal to or greater than a predetermined value to the switching unit 16. As the control unit 17, for example, a gate driver is used.

In the present exemplary embodiment, in a case where the transistor 151 is in the non-conduction state and the switching unit 16 is in the conduction state, the resonant circuit RC is being not conductive, while the circuit from the power supply 13 to the capacitor 14 is being conductive. In such a case, electric charge is supplied from the power supply 13 to the capacitor 14, and the capacitor 14 is charged.

Further, in a case where the transistor 151 is in a conduction state and the switching unit 16 is in a non-conduction state, the resonant circuit RC is being conductive, while the circuit from the power supply 13 to the capacitor 14 is being not conductive. In such a case, the light emitting element 11 emits light by supplying a current from the capacitor 14 to the light emitting element 11. Further, after the current is supplied from the capacitor 14 to the light emitting element 11, the transistor 151 is put into the non-conduction state and the switching unit 16 is put into the conduction state again, and the capacitor 14 is charged. As described above, in the present exemplary embodiment, charging of the capacitor 14 and light emission of the light emitting element 11 by supplying a current from the capacitor 14 to the light emitting element 11 are repeatedly performed. Thereby, the light emitting element 11 intermittently emits pulsed light.

As described above, in the present exemplary embodiment, the switching unit 16 is connected to the circuit between the power supply 13 and the resonant circuit RC. Then, the switching unit 16 switches between a conduction state in which the circuit from the power supply 13 to the resonant circuit RC is conductive and a non-conduction state in which the circuit is not conductive.

Here, a method of causing the light emitting element 11 to emit light by supplying a current generated by resonance to the light emitting element 11 with a configuration different from the configuration of the present exemplary embodiment is also conceivable. For example, there is a configuration in which the light emitting element 11 is made to emit light by supplying the light emitting element 11 with the current generated by resonance, in a state where the circuit from the power supply 13 to the resonant circuit RC is constantly conductive, without providing the switching unit 16 in the circuit between the power supply 13 and the resonant circuit RC. However, according to such a configuration, electric charge may be supplied from the power supply 13 to the capacitor 14 even in a case where resonance is being generated. As described above, in a case where the resonant circuit RC is affected by the circuit outside the resonant circuit RC while the resonance is being generated, the resonance in the resonant circuit RC may be attenuated.

Therefore, in the present exemplary embodiment, attenuation of resonance in the resonant circuit RC is suppressed by using a configuration of switching between a state in which the circuit from the power supply 13 to the resonant circuit RC is conductive and a state in which the circuit is not conductive, compared with the configuration in which the circuit from the power supply 13 to the resonant circuit RC is constantly conductive.

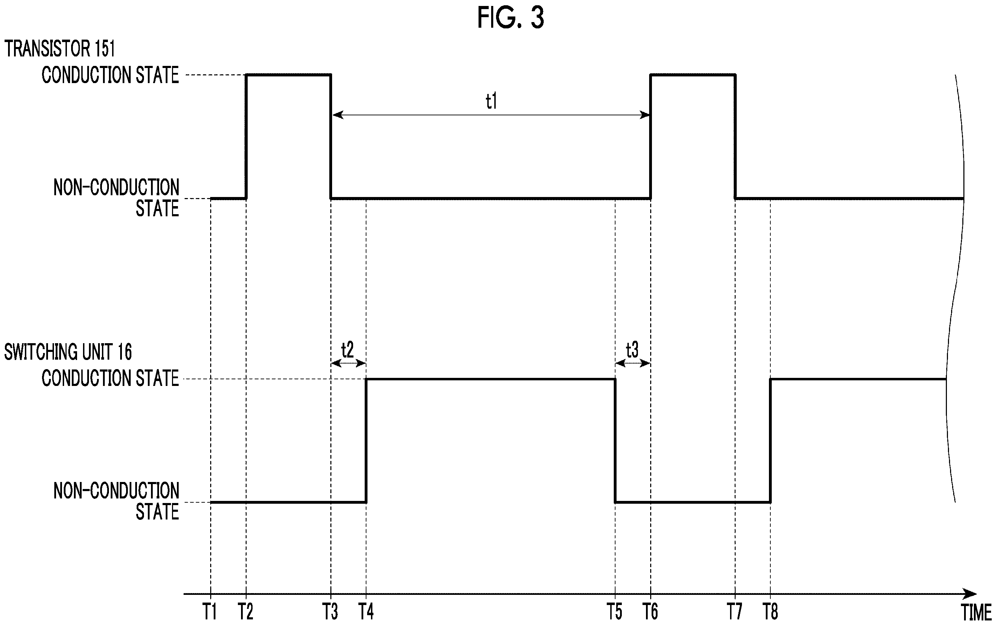

Fig. 3 is a diagram showing the relationship between the timing at which the state of the transistor 151 is switched and the timing at which the state of the switching unit 16 is switched.

First, at the time point T1, the transistor 151 is in the non-conduction state, and the switching unit 16 is in the non-conduction state. At the time point T1, it is assumed that the charging of the capacitor 14 is completed. At this time, the capacitor 14 does not supply a current to the light emitting element 11, and the power supply 13 does not supply electric charge to the capacitor 14.

Next, at the time point T2, the transistor 151 switches from the non-conduction state to the conduction state. On the other hand, the switching unit 16 is in a non-conduction state. In such a case, the light emitting element 11 emits light in a case where the capacitor 14 supplies a current to the light emitting element 11. At this time, the current supplied from the capacitor 14 to the light emitting element 11 is the current generated by resonance in the resonant circuit RC. Further, the power supply 13 does not supply electric charge to the capacitor 14.

Then, at the time point T3, the transistor 151 switches from the conduction state to the non-conduction state. Further, at this time, the switching unit 16 is in a non-conduction state. In such a case, the capacitor 14 does not supply a current to the light emitting element 11, and the power supply 13 does not supply electric charge to the capacitor 14.

Then, at the time point T4, the control unit 17 turns on the switching unit 16. Therefore, the switching unit 16 switches from the non-conduction state to the conduction state. Further, at this time, the transistor 151 is in a non-conduction state. In such a case, the power supply 13 supplies electric charge to the capacitor 14, and the capacitor 14 is charged.

Then, charging of the capacitor 14 is completed.

Then, at the time point T5, the control unit 17 turns off the switching unit 16. Therefore, the switching unit 16 switches from the conduction state to the non-conduction state. At this time, the transistor 151 is in a non-conduction state. In such a case, the capacitor 14 does not supply a current to the light emitting element 11, and the power supply 13 does not supply electric charge to the capacitor 14.

Then, at the time point T6, the transistor 151 switches from the non-conduction state to the conduction state. At this time, the switching unit 16 is in a non-conduction state. In such a case, the capacitor 14 supplies a current to the light emitting element 11. Therefore, the light emitting element 11 re-emits light. On the other hand, the power supply 13 does not supply electric charge to the capacitor 14.

Then, at the time point T7, the transistor 151 switches from the conduction state to the non-conduction state. At this time, the switching unit 16 is in a non-conduction state. In such a case, the capacitor 14 does not supply a current to the light emitting element 11, and the power supply 13 does not supply electric charge to the capacitor 14.

Then, at the time point T8, the control unit 17 turns on the switching unit 16. Therefore, the switching unit 16 switches from the non-conduction state to the conduction state. At this time, the transistor 151 is in a non-conduction state. In such a case, the power supply 13 supplies electric charge to the capacitor 14, and the capacitor 14 is charged again.

In the present exemplary embodiment, a timing at which the transistor 151 is turned on is determined on the basis of a timing at which the charging of the capacitor 14 is completed. More specifically, the timing at which the transistor 151 is turned on is determined such that the transistor 151 switches from the non-conduction state to the conduction state after the charging of the capacitor 14 is completed.

Further, a timing at which the transistor 151 is turned off is determined on the basis of a timing at which there is no electric charge to be accumulated in the capacitor 14. More specifically, the timing at which the transistor 151 is turned off is determined such that the transistor 151 switches from the conduction state to the non-conduction state after there is no electric charge to be accumulated in the capacitor 14 by causing the capacitor 14 to supply the current necessary for one light emission of the light emitting element 11.

Further, in the present exemplary embodiment, as described above, the detection apparatus 1 sets the distance to the target object T as a detection target from a plurality of stages. Then, the time period t1 from switching of the transistor 151 to the non-conduction state to switching of the transistor 151 to the conduction state is determined in accordance with a distance which is set in the detection apparatus 1 as the detection target. It is determined that the time period t1 is longer as the distance which is set in the detection apparatus 1 as the detection target is longer. Here, the time period t1 is also taken as a time interval from light emission of the light emitting element 11 to re-emission of the light emitting element 11.

Further, a timing at which the control unit 17 puts the switching unit 16 into an ON state is determined on the basis of a timing at which the transistor 151 is OFF. More specifically, a timing at which the control unit 17 puts the switching unit 16 into an ON state is determined such that the switching unit 16 switches from the non-conduction state to the conduction state in a case where the time period t2 elapses after the transistor 151 is switched to the non-conduction state.

Further, a timing at which the control unit 17 puts the switching unit 16 into an OFF state is determined on the basis of a timing at which the transistor 151 is turned ON. More specifically, a timing at which the control unit 17 turns off the switching unit 16 is determined such that the switching unit 16 switches from the conduction state to the non-conduction state at a time which is earlier by the time period t3 than a time at which the transistor 151 switches from the non-conduction state to the conduction state.

In the present exemplary embodiment, a timing at which the control unit 17 applies the voltage to the switching unit 16 is set in advance in the control unit 17. Therefore, the timing at which the switching unit 16 is turned on and the timing at which the switching unit 16 is turned off are determined. Further, by setting the timing at which the voltage is applied to the transistor 151 to the operation unit 15 in advance, the timing at which the transistor 151 is turned on and the timing at which the transistor 151 is turned off are determined. A user of the detection apparatus 1 performs both setting of the timing at which the control unit 17 applies the voltage to the switching unit 16 and setting of the timing at which the voltage is applied to the transistor 151.

As described above, in the present exemplary embodiment, the switching unit 16 is in a non-conduction state in a case where the capacitor 14 supplies the current to the light emitting element 11.

In particular, in the present exemplary embodiment, in a case where the switching unit 16 is in the conduction state and the transistor 151 is in the non-conduction state, the control unit 17 puts the switching unit 16 into the non-conduction state before the transistor 151 switches to the conduction state.

Further, in the present exemplary embodiment, the switching unit 16 is in a conduction state in a case where the capacitor 14 does not supply a current to the light emitting element 11.

In particular, in the present exemplary embodiment, in a case where the switching unit 16 is in the non-conduction state and the transistor 151 is in the conduction state, the control unit 17 puts the switching unit 16 into the conduction state after the transistor 151 is switched to the non-conduction state.

Further, in the present exemplary embodiment, the time at which the transistor 151 is conductive and the time at which the transistor 151 is non-conduction state are predetermined. Then, the time, at which the control unit 17 puts the switching unit 16 into the non-conduction state, is determined in accordance with a time at which the transistor 151 becomes the conduction state, and the time, at which the control unit 17 puts the switching unit 16 into the conduction state, is determined in accordance with a time at which the transistor 151 becomes the non-conduction state.

Further, in the present exemplary embodiment, the time period from the non-conduction state of the transistor 151 to the conduction state is determined in accordance with the distance to the target object T which is set in the detection apparatus 1 as the detection target. More specifically, it is defined that the longer the distance to the target object T included in the detection apparatus 1 as the detection target, the longer the time period from the non-conduction state to the conduction state of the transistor 151.

Even in a case where the distance to the target object T which is set in the detection apparatus 1 as the detection target is long, a time interval between the end of the light emission and the light re-emission of the light emitting element 11 may be short. In such a case, the light emitting element 11 may emit light a plurality of times until the light receiving unit 20 receives the light once. In such a case, it is difficult for the detection unit 30 to identify which of the light received by the light receiving unit 20 is based on the light emitted from the light emitting element 11 at which timing. Therefore, in the present exemplary embodiment, the time period from the non-conduction state to the conduction state of the transistor 151 is determined in accordance with the distance to the target object T which is set in the detection apparatus 1 as the detection target.

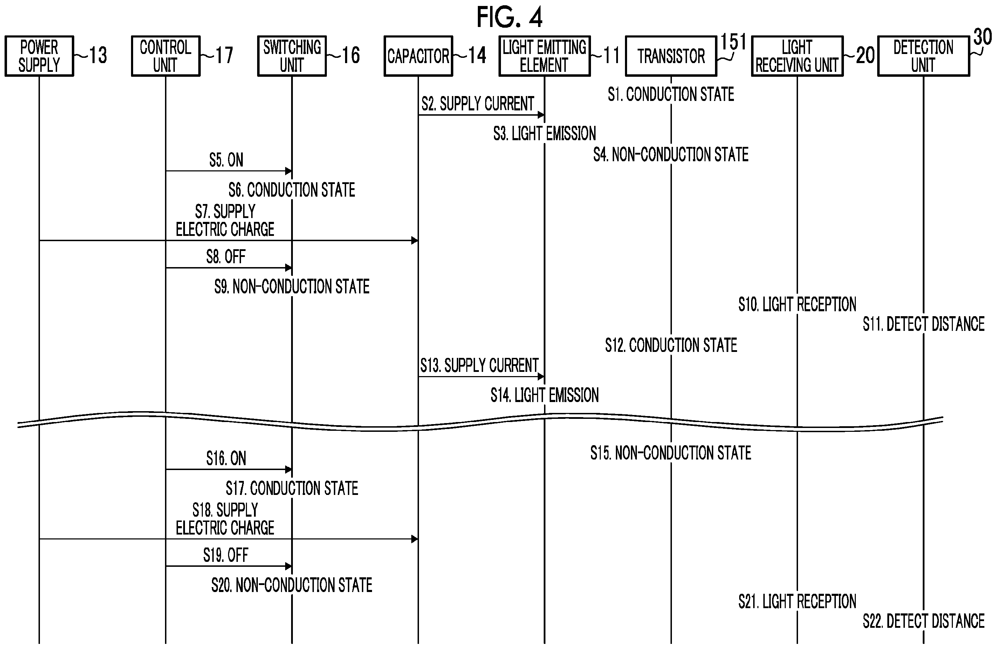

Fig. 4 is a diagram showing an operation in which the detection apparatus 1 according to the present invention detects the distance to the target object T.

First, the transistor 151 of the operation unit 15 becomes the conduction state (step (hereinafter referred to as "S") 1). At this time, it is assumed that charging of the capacitor 14 is completed and the switching unit 16 is in a non-conduction state.

The capacitor 14 supplies a current to the light emitting element 11 (S2).

The light emitting element 11 emits light in a case where a current is supplied from the capacitor 14 (S3).

The transistor 151 becomes a non-conduction state (S4).

The control unit 17 turns on the switching unit 16 (S5). Thereby, the switching unit 16 becomes conduction state (S6).

The power supply 13 supplies electric charge to the capacitor 14 (S7). Thereby, the capacitor 14 is charged.

The control unit 17 puts the switching unit 16 into an OFF state (S8). Thereby, the switching unit 16 is in a non-conduction state (S9).

Then, the light receiving unit 20 receives light (S10). More specifically, the light receiving unit 20 receives the light generated by irradiating the target object T with the light emitted from the light emitting element 11 in step S3.

The detection unit 30 detects the distance to the target object T on the basis of the light received by the light receiving unit 20 (S11).

Then, the transistor 151 becomes the conduction state again (S12).

The capacitor 14 supplies a current to the light emitting element 11 (S13).

The light emitting element 11 re-emits light in a case where the current in the resonant circuit RC is supplied from the capacitor 14 (S14).

Then, each time period the current is supplied from the capacitor 14 to the light emitting element 11, the capacitor 14 is charged, the light receiving unit 20 receives the light, and the detection apparatus 1 detects the distance to the target object T.

Then, in a case where the final light emission of the plurality of light emissions by the light emitting element 11 is performed, the transistor 151 is put into a non-conduction state (S15).

The control unit 17 puts the switching unit 16 (S16) into an ON state. Thereby, the switching unit 16 becomes the conduction state (S17).

The power supply 13 supplies electric charge to the capacitor 14 (S18). Thereby, the capacitor 14 is charged.

The control unit 17 puts the switching unit 16 into an OFF state (S19). Thereby, the switching unit 16 is in a non-conduction state (S20).

Then, the light receiving unit 20 receives the light (S21).

The detection unit 30 detects the distance to the target object T on the basis of the light received by the light receiving unit 20 (S22).

Here, as shown in Fig. 4, a configuration will be described in which the detection apparatus 1 of the present exemplary embodiment completes charging of the capacitor 14 during the time period from light emission of the light emitting device 10 to light reception of the light receiving unit 20.

In the present exemplary embodiment, it is assumed that an inductance in the resonant circuit RC is 0.4 nH and a capacitance of the capacitor 14 is 200 pF. Further, it is assumed that an electric resistance in the electric path from the power supply 13 to the resonant circuit RC is 10Ω. Further, it is assumed that the distance to the target object T which is set as a detection target by the detection apparatus 1 is 10 m.

The light emitting element 11 of the present exemplary embodiment emits light in a case where a current generated by resonance is supplied. In such a case, Relational Expression (2) is established between the resonant circuit RC and the light emitted from the light emitting element 11.

$$ f = \frac{1}{2\pi\sqrt{LC}} \quad \cdots (2) $$

In Expression (2), f is the resonance frequency of the light emitted from the light emitting element 11. The resonance frequency of light is the frequency of light emitted from the light emitting element 11 in a case where resonance is being generated. Further, L is the inductance in the resonant circuit RC. Further, C is the capacitance of the capacitor 14.

Substituting the inductance L of the resonant circuit RC and the capacitance C of the capacitor 14 into Expression (2), $f \approx 5.63 \times 10^8$ is calculated as the resonance frequency f.

Next, a method of calculating the time period from the start of emission of the light from the light emitting device 10 to the emission of the light having the maximum intensity will be described. In addition, in the present exemplary embodiment, it is assumed that reflected light is generated in a case where the target object T is irradiated with the light which is emitted from the light emitting device 10 and has the maximum intensity. Therefore, first, a time period from the start of emission of the light from the light emitting device 10 to the emission of the light having the maximum intensity is calculated.

An intensity of the light emitted from the light emitting element 11 changes into a wave shape with the passage of time. Specifically, at a timing in a case where the emission of the light from the light emitting element 11 is started, the intensity of the emitted light is a reference, and then the intensity of the emitted light is maximized. Subsequently, the intensity of the emitted light returns to the reference, and then the intensity of the emitted light is minimized. Further, then, the intensity of the emitted light returns to the reference again. In such a manner, the intensity of the light emitted from the light emitting element 11 changes periodically. Further, regarding the intensity of the light emitted from the light emitting element 11, the time period from the reference to the maximum, the time period from the maximum to the reference, the time period from the reference to the minimum, and the time period from the minimum to the reference again are all the same time period. Therefore, the time period Tc from the start of emission of the light from the light emitting device 10 to the emission of the light having the maximum intensity is calculated from Expression (3).

$$T_c = T_p / 4 \qquad \cdots (3)$$

In Expression (3), Tp is a period of oscillation in the emitted light. The period Tp is calculated from Expression (4).

$$T_p = 1 / f \qquad \cdots (4)$$

By substituting the resonance frequency f into Expression (4), $T_p \approx 1.78 \times 10^{-9}$ is calculated as the period Tp. Further, by substituting the period Tp into Expression (3), $T_c = 4.45 \times 10^{-10}$ seconds is calculated as the time period Tc.

Next, a method of calculating the time period from emission of the light having the maximum intensity from the light emitting device 10 to light reception of the light receiving unit 20 will be described. The time period Tr from emission of the light from the light emitting device 10 to light reception of the light receiving unit 20 is calculated from Expression (5).

$$T_r = 2L_t / c \qquad \cdots (5)$$

In Expression (5), Lt is the distance from the detection apparatus 1 to the target object T. Further, c is a speed of the light. By substituting the distance Lt and the speed c into Expression (5), $Tr \approx 66.7 \times 10^{-9}$ seconds is calculated as the time period Tr.

Next, a method of calculating the time period from the start of emission of the light from the light emitting device 10 to light reception of the light receiving unit 20 will be described. Since the time period Ts from the start of emission of the light from the light emitting device 10 to the reception by the light receiving unit 20 is the sum of the time period Tc and the time period Tr, $Ts \approx 67.1 \times 10^{-9}$ seconds is calculated as the time period Ts.

Next, a method of calculating the time period necessary to charge the capacitor 14 will be described. The relationship of Expression (6) is established in the time period in which the capacitor 14 is charged, the electric resistance, and the capacitance C of the capacitor 14.

$$T_t = RC \qquad \cdots (6)$$

In Expression (6), Tt is a time constant for charging the capacitor 14, and R is an electric resistance of the electric path from the power supply 13 to the resonant circuit RC. The time constant Tt is the time period necessary for the capacitor 14 to be charged to 63% of the capacity thereof. By substituting the electric resistance R and the capacitance C into Expression (6), $Tt=2 \times 10^{-9}$ seconds is calculated as the time constant Tt.

Next, a method of calculating the time period from the start of charging of the capacitor 14 to the completion of charging will be described. In a case where a time period five times the time constant Tt elapses from the start of charging of the capacitor 14, the capacitor 14 is charged to 99.3% of the capacity thereof. That is, in a case where a time period five times the time constant Tt elapses after the charging of the capacitor 14 is started, the charging of the capacitor 14 is completed. Therefore, $Tz=5 \times Tt=10 \times 10^{-9}$ seconds is calculated as the time period Tz from the start of charging of the capacitor 14 to the completion of charging.

As described above, the time period Ts from the start of emission of the light from the light emitting device 10 to the light reception by the light receiving unit 20 is $67.1 \times 10^{-9}$ seconds. In contrast, the time period Tz from the start of the charging of the capacitor 14 to the completion of charging is $10 \times 10^{-9}$ seconds. That is, in the present exemplary embodiment, the charging of the capacitor 14 is completed from light emission of the light emitting device 10 to light reception of the light receiving unit 20.

In the present exemplary embodiment, it has been described that the electric resistance of the electric path from the power supply 13 to the resonant circuit RC in a case where the switching unit 16 is in a conduction state is 10Ω, but the present invention is not limited to this.

For example, it is assumed that the electric resistance of the electric path from the power supply 13 to the resonant circuit RC is 50Ω in a case where the switching unit 16 is in a conduction state. In such a case, $Tt=10 \times 10^{-9}$ seconds is calculated as the time constant Tt. Further, the time period Tz from the start of charging of the capacitor 14 to the completion of charging is calculated as $Tz=5 \times Tt=50 \times 10^{-9}$ seconds. Even in such a case, the charging of the capacitor 14 is completed from light emission of the light emitting device 10 emits light to light reception of the light receiving unit 20. That is, in order to complete the charging of the capacitor 14 from light emission of the light emitting device 10 to light reception of the light receiving unit 20, an electric resistance of the electric path from the power supply 13 to the resonant circuit RC in a case where the switching unit 16 is in a conduction state may be 50Ω or less.

As described above, in the present exemplary embodiment, the electric charge necessary to supply the current for light emission of the light emitting element 11 is accumulated in the capacitor 14 from supply of the current necessary for light emission of the light emitting element 11 from the capacitor 14 to light reception of the light receiving unit 20 on the basis of the light emission.

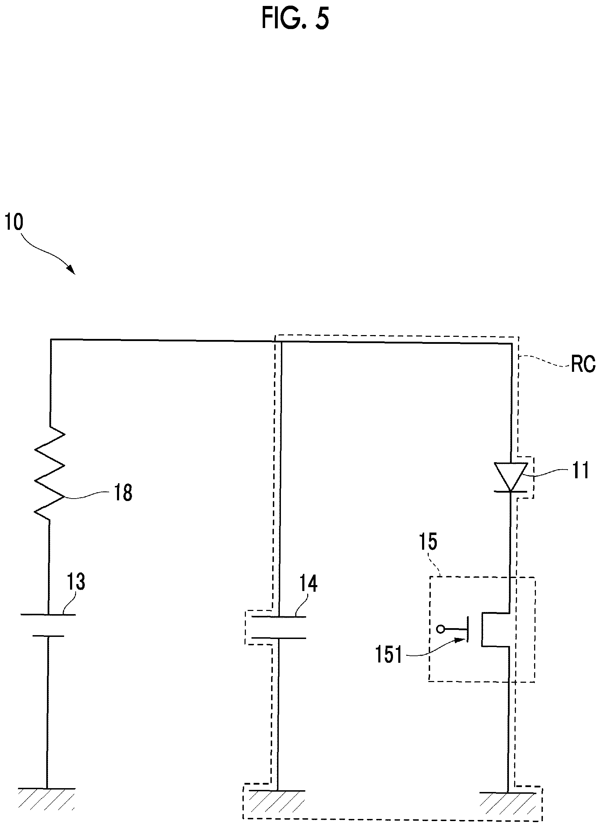

Fig. 5 is a diagram showing a comparative example.

In the comparative example, the resistor 18 is connected to the electric path between the power supply 13 and the resonant circuit RC. Then, the resistor 18 suppresses the supply of electric charge from the power supply 13 to the capacitor 14, thereby suppressing the attenuation of resonance in the resonant circuit RC.

The resistor 18 has a predetermined electric resistance. In the comparative example, the resistor 18 is used, which has an electric resistance determined such that the electric resistance in the electric path from the power supply 13 to the resonant circuit RC is the lower limit value of the electric resistance necessary for attenuation of the resonance in the resonant circuit RC. The lower limit value of the electric resistance necessary for the attenuation of resonance in the resonant circuit RC may be referred to as an electric resistance R1 below. The electric resistance R1 is an example of the first electric resistance. Further, the electric resistance of the electric path from the power supply 13 to the resonant circuit RC in the light emitting device 10 of the present exemplary embodiment may be referred to as an electric resistance R2 below. The electric resistance R2 is an example of the second electric resistance.

Even with the configuration shown in Fig. 5, the attenuation of resonance in the resonant circuit RC is suppressed. On the other hand, according to such a configuration, as it is more difficult to supply the electric charge from the power supply 13 to the capacitor 14 due to the electric resistance of the resistor 18, the time period necessary to charge the capacitor 14 is longer.

Therefore, in the present exemplary embodiment, the switching unit 16 is provided in the circuit between the power supply 13 and the capacitor 14 without providing a resistor. In such a configuration, the electric resistance of the electric path from the power supply 13 to the resonant circuit RC in a case where the switching unit 16 is in a conduction state is smaller than the electric resistance R1. In such a case, as compared with the comparative example, as it is easier to supply the electric charge from the power supply 13 to the capacitor 14, the time period necessary to charge the capacitor 14 is shorter.

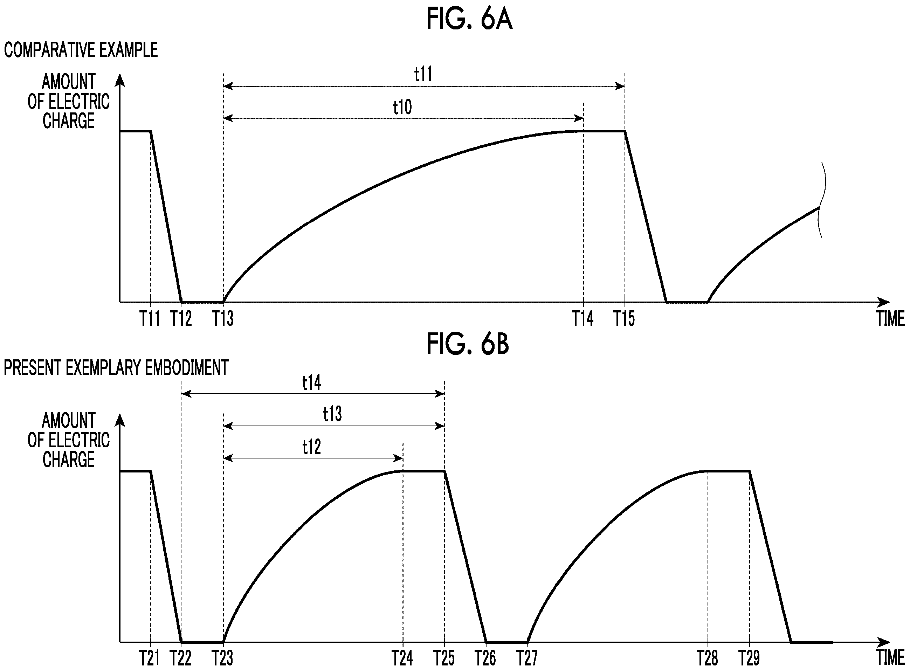

Fig. 6A is a diagram showing a relationship between the time period and change in amount of electric charge of the capacitor 14 due to an operation of the light emitting device 10 in a comparative example, and Fig. 6B is a diagram showing a relationship between the time period and change in amount of electric charge of the capacitor 14 due to an operation of the light emitting device 10 in the present exemplary embodiment.

In the light emitting device 10 in the comparative example, as shown in Fig. 6A, the charging of the capacitor 14 is completed at the time point T11, and the electric charge is accumulated in the capacitor 14. At this time, the transistor 151 becomes the conduction state, and the supply of current from the capacitor 14 to the light emitting element 11 is started. Thereby, the light emitting element 11 starts to emit light.

Then, at the time point T12, there is no electric charge to be accumulated in the capacitor 14. Further, at this time, the transistor 151 is put into a non-conduction state, and the light emitting element 11 is turned off.

Then, at the time point T13, supply of electric charge from the power supply 13 to the capacitor 14 is started, and charging of the capacitor 14 is started.

Then, at the time point T14, a necessary amount of electric charge is supplied from the power supply 13 to the capacitor 14. Thereby, the charging of the capacitor 14 is completed. The necessary amount of electric charge is the amount of electric charge necessary to be accumulated in the capacitor 14 in order for the light emitting element 11 to emit light by causing the capacitor 14 to supply a current to the light emitting element 11. The necessary amount of electric charge is an example of the first amount of electric charge.

Then, at the time point T15, the transistor 151 becomes the conduction state, and the supply of current from the capacitor 14 to the light emitting element 11 is restarted. Thereby, the light emission of the light emitting element 11 is restarted.

In the comparative example, the time period from the start to the completion of charging of the capacitor 14 is the time period t10 from the time point T13 to the time point T14. The time period from start of the charging of the capacitor 14 is started to light emission of the light emitting element 11 is a time period t11 from the time point T13 to the time point T15.

Further, in the light emitting device 10 of the present exemplary embodiment, as shown in Fig. 6B, the charging of the capacitor 14 is completed at the time point T21, and the electric charge is accumulated in the capacitor 14. At this time, the transistor 151 becomes the conduction state, and the supply of current from the capacitor 14 to the light emitting element 11 is started. Thereby, the light emitting element 11 starts to emit light.

Then, at the time point T22, there is no electric charge to be accumulated in the capacitor 14. Further, at this time, the transistor 151 is put into a non-conduction state, and the light emitting element 11 is turned off.

Then, at the time point T23, the switching unit 16 becomes the conduction state, the supply of electric charge from the power supply 13 to the capacitor 14 is started, and the charging of the capacitor 14 is started.

Then, at the time point T24, the necessary amount of electric charge is supplied from the power supply 13 to the capacitor 14. Thereby, the charging of the capacitor 14 is completed. Then, the switching unit 16 becomes the non-conduction state.

Then, at the time point T25, the transistor 151 becomes the conduction state, and the supply of current from the capacitor 14 to the light emitting element 11 is restarted. Thereby, the light emission of the light emitting element 11 is restarted.

Then, at the time point T26, there is no electric charge to be accumulated in the capacitor 14 again. Further, at this time, the transistor 151 is put into a non-conduction state, and the light emitting element 11 is turned off.

Then, at the time point T27, the switching unit 16 becomes the conduction state, the supply of electric charge from the power supply 13 to the capacitor 14 is started, and the charging of the capacitor 14 is started again.

Then, at the time point T28, the necessary amount of electric charge is supplied from the power supply 13 to the capacitor 14. Thereby, the charging of the capacitor 14 is completed. Then, the switching unit 16 becomes the non-conduction state.

Then, at the time point T29, the transistor 151 becomes the conduction state, and the supply of current from the capacitor 14 to the light emitting element 11 is restarted. Thereby, the light emission of the light emitting element 11 is restarted.

In the present exemplary embodiment, the time period from the start to the completion of charging of the capacitor 14 is the time period t12 from the time point T23 to the time point T24. The time period from start of the charging of the capacitor 14 is started to light emission of the light emitting element 11 emits light is a time period t13 from the time point T23 to the time point T25. The time period from the end of light emission of the light emitting element 11 to the light re-emission of the light emitting element 11 is the time period t14 from the time point T22 to the time point T25.

Here, the time period t12 is shorter than the time period t10. Also, the time period t13 is shorter than the time period t10. Furthermore, the time period t14 is shorter than the time period t10.

That is, in the present exemplary embodiment, in a case where the electric resistance of the electric path from the power supply 13 to the resonant circuit RC is the electric resistance R1, the time period necessary to supply the necessary amount of electric charge from the power supply 13 to the capacitor 14 is the time period t10. In a case where the electric resistance of the electric path from the power supply 13 to the resonant circuit RC is the electric resistance R2, the time period from the end of light emission of the light emitting element 11 to the light re-emission of the light emitting element 11 is the time period t14 shorter than the time period t10.

In the present exemplary embodiment, it has been described that the circuit between the power supply 13 and the capacitor 14 is not provided with a resistor, but the present invention is not limited to this.

In a case where the electric resistance of the electric path from the power supply 13 to the resonant circuit RC in a case where the switching unit 16 is in a conduction state is smaller than the electric resistance R1, a resistor may be provided in the circuit between the power supply 13 and the capacitor 14.

Further, in the present exemplary embodiment, it has been described that in a case where the capacitor 14 supplies a current to the light emitting element 11, the switching unit 16 is constantly in a non-conduction state, in accordance with the present invention.

In a comparative example which is not part of the claimed invention, in a case where the switching unit 16 is constantly in a non-conduction state in a case where the capacitor 14 supplies a current to the light emitting element 11, the switching unit 16 may be in a conduction state in a case where the capacitor 14 supplies a current to the light emitting element 11. Even in such a case, attenuation of resonance in the resonant circuit RC is suppressed as compared with the configuration in which the circuit from the power supply 13 to the resonant circuit RC is being constantly conductive.

Although the exemplary embodiments of the present invention have been described above, the technical scope of the present invention is not limited to the scope described in the above exemplary embodiments.

The foregoing description of the exemplary embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.

Brief Description of the Reference Symbols

1:      detection apparatus
10:    light emitting device
11:    light emitting element
12:    substrate
13:    power supply
14:    capacitor
15:    operation unit
16:    switching unit
17:    control unit
20:    light receiving unit
30:    detection unit
151:  transistor
RC:   resonant circuit

**Claims**

1.  A detection apparatus (1) comprising:

    a light emitting device (10);
    a light receiving unit (20) that is configured to receive light based on irradiation of a target object (T) with light emitted from the light emitting device (10); and
a detection unit (30) that is configured to detect a distance to the target object (T) on the basis of light reception of the light receiving unit (20), wherein the light emitting device (10) comprises:

a resonant circuit (RC) comprising a capacitor (14) configured to accumulate electric charge and generate a current by resonance occurring in the resonant circuit (RC);
a light emitting element (11) that is configured to emit light in response to receiving the current generated by the resonance occurring in the resonant circuit (RC);
a first switching unit (16) that is connected to a circuit between a power supply (13) that supplies electric charge to the capacitor (14) and the resonant circuit (RC); and
a second switching unit (151) that is configured to switch between a conduction state in which the resonant circuit (RC) is conductive and a non-conduction state in which the resonant circuit (RC) is not conductive,
wherein the first switching unit (16) is configured to switch between a conduction state in which a circuit from the power supply (13) to the resonant circuit (RC) is conductive and a non-conduction state in which the circuit is not conductive,
wherein the first switching unit (16) is in the non-conduction state when the capacitor (14) supplies the current generated by the resonance occurring in the resonant circuit (RC) to the light emitting element (11), and
the first switching unit (16) is configured to be switched to the conduction state after a current necessary for light emission of the light emitting element (11) is supplied from the capacitor (14) to the light emitting element (11), and
wherein, after the current necessary for light emission of the light emitting element (11) is supplied from the capacitor (14),
the electric charge necessary for supply of a current for causing the light emitting element (11) to emit light is accumulated in the capacitor (14) during a time period from light emission of the light emitting element (11) to light reception of the light receiving unit (20),
**characterized in that** the detection apparatus (1) is configured to set a distance of 10 m as a distance to the target object (T) and to set the distance to the target object (T) as a detection target,
wherein a time period from a time at which the second switching unit (151) becomes the non-conduction state to a time at which the second switching unit (151) becomes the conduction state is determined in accordance with the distance to the target object (T) that is set as the detection target in the detection apparatus (1).

2. The detection apparatus (1) according to claim 1, wherein the light emitting device (10) further comprises a switching control unit (17) that is configured to switch the first switching unit (16) to the non-conduction state before the second switching unit (151) is switched to the conduction state in a case where the first switching unit (16) is in the conduction state and the second switching unit (151) is in the non-conduction state.

3. The detection apparatus (1) according to claim 1, wherein the first switching unit (16) is in the conduction state in a case where the capacitor (14) does not supply a current to the light emitting element (11).

4. The detection apparatus (1) according to claim 3,

wherein the light emitting device (10) further comprises
a switching control unit (17) that is configured to switch the first switching unit (16) to the conduction state after the second switching unit (151) is switched to the non-conduction state in a case where the first switching unit (16) is in the non-conduction state and the second switching unit (151) is in the conduction state.

5. The detection apparatus (1) according to claim 1,

wherein the light emitting device (10) further comprises a switching control unit (17) that is configured to switch the first switching unit (16) between the conduction state and the non-conduction state,
wherein the time at which the second switching unit (151) becomes the conduction state and the time at which the second switching unit (151) becomes the non-conduction state are predetermined, and a time at which the switching control unit (17) puts the first switching unit (16) into the non-conduction state is determined, depending on the time at which the second switching unit (151) becomes the conduction state, and
a time at which the switching control unit (17) puts the first switching unit (16) into the conduction state is determined, depending on the time at which the second switching unit (151) becomes the nonconduction state.

**6.** The detection apparatus (1) according to claim 1,

wherein in an electric path from the power supply (13) to the resonant circuit (RC), a lower limit value of an electric resistance necessary to suppress attenuation of the resonance is a first electric resistance (R1), and an electric resistance of the electric path from the power supply to the resonant circuit in a case where the first switching unit is in the conduction state is a second electric resistance (R2) smaller than the first electric resistance (R1).

**Patentansprüche**

**1.** Detektionsvorrichtung (1), umfassend:

eine lichtemittierende Vorrichtung (10); eine lichtempfangende Einheit (20), die so konfiguriert ist, dass sie Licht auf der Grundlage von Bestrahlung eines Zielobjekts (T) mit Licht, das von der lichtemittierenden Vorrichtung (10) emittiert wird, empfängt; und eine Detektionseinheit (30), die so konfiguriert ist, dass sie eine Entfernung zu dem Zielobjekt (T) auf der Grundlage von Lichtempfang der lichtempfangenden Einheit (20) detektiert, wobei die lichtemittierende Vorrichtung (10) umfasst:

einen Resonanzkreis (RC), der einen Kondensator (14) umfasst, der so konfiguriert ist, dass er elektrische Ladung akkumuliert und einen Strom durch Resonanz, die in dem Resonanzkreis (RC) auftritt, erzeugt; ein lichtemittierendes Element (11), das so konfiguriert ist, dass es Licht als Reaktion auf Empfangen des durch die Resonanz, die in dem Resonanzkreis (RC) auftritt, erzeugten Stroms emittiert; eine erste Schalteinheit (16), die mit einem Stromkreis zwischen einer Stromversorgung (13), die dem Kondensator (14) elektrische Ladung zuführt, und dem Resonanzkreis (RC) verbunden ist; und eine zweite Schalteinheit (151), die so konfiguriert ist, dass sie zwischen einem Leitungszustand, in dem der Resonanzkreis (RC) leitfähig ist, und einem Nichtleitungszustand, in dem der Resonanzkreis (RC) nicht leitfähig ist, umschaltet, wobei die erste Schalteinheit (16) so konfiguriert ist, dass sie zwischen einem Leitungszustand, in dem ein Stromkreis von der Stromversorgung (13) zu dem Resonanzkreis (RC) leitfähig ist, und einem Nichtleitungszustand, in dem der Stromkreis nicht leitfähig ist, umschaltet, wobei die erste Schalteinheit (16) in dem Nichtleitungszustand ist, wenn der Kondensator (14) den Strom, der durch die bei dem Resonanzkreis (RC) auftretende Resonanz erzeugt wird, dem lichtemittierenden Element (11) zuführt, und die erste Schalteinheit (16) so konfiguriert ist, dass sie in den Leitungszustand umgeschaltet wird, nachdem ein für Lichtemission des lichtemittierenden Elements (11) notwendiger Strom von dem Kondensator (14) dem lichtemittierenden Element (11) zugeführt worden ist, und wobei, nachdem der Strom, der für Lichtemission des lichtemittierenden Elements (11) notwendig ist, von dem Kondensator (14) zugeführt worden ist, die elektrische Ladung, die für Zufuhr eines Stroms zum Veranlassen des lichtemittierenden Elements (11), Licht zu emittieren, notwendig ist, in dem Kondensator (14) während eines Zeitraums von Lichtemission des lichtemittierenden Elements (11) bis Lichtempfang der lichtempfangenden Einheit (20) akkumuliert wird, **dadurch gekennzeichnet, dass** die Detektionsvorrichtung (1) so konfiguriert ist, dass sie eine Entfernung von 10 m als eine Entfernung zu dem Zielobjekt (T) einstellt und die Entfernung zu dem Zielobjekt (T) als ein Detektionsziel einstellt, wobei ein Zeitraum von einem Zeitpunkt, zu dem die zweite Schalteinheit (151) in den Nichtleitungszustand übergeht, bis zu einer Zeit, zu der die zweite Schalteinheit (151) in den Leitungszustand übergeht, in Übereinstimmung mit der Entfernung zu dem Zielobjekt (T), das als das Detektionsziel in der Detektionsvorrichtung (1) eingestellt ist, bestimmt wird.

**2.** Detektionsvorrichtung (1) nach Anspruch 1, wobei die lichtemittierende Vorrichtung (10) ferner eine Schaltsteuereinheit (17) umfasst, die so konfiguriert ist, dass sie die erste Schalteinheit (16) in den Nichtleitungszustand umschaltet, bevor die zweite Schalteinheit (151) in den Leitungszustand umgeschaltet wird, in einem Fall, in dem die erste Schalteinheit (16) in dem Leitungszustand und die zweite Schalteinheit (151) in dem Nichtleitungszustand ist.

**3.** Detektionsvorrichtung (1) nach Anspruch 1, wobei die erste Schalteinheit (16) in dem Leitungszustand in einem Fall ist, in dem der Kondensator (14) dem lichtemittierenden Element (11) keinen Strom zuführt.

**4.** Detektionsvorrichtung (1) nach Anspruch 3, wobei die lichtemittierende Vorrichtung (10) ferner umfasst:
eine Schaltsteuereinheit (17), die so konfiguriert ist, dass sie die erste Schalteinheit (16) in den Leitungszustand umschaltet, nachdem die zweite Schalteinheit (151) in den Nichtleitungszustand umgeschaltet wird, in einem Fall, in dem die erste Schalteinheit (16) in dem Nichtleitungszustand und die zweite Schalteinheit (151) in dem Leitungszustand ist.

**5.** Detektionsvorrichtung (1) nach Anspruch 1,

wobei die lichtemittierende Vorrichtung (10) ferner eine Schaltsteuereinheit (17) umfasst, die so konfiguriert ist, dass sie die erste Schalteinheit (16) zwischen dem Leitungszustand und dem Nichtleitungszustand umschaltet,
wobei die Zeit, zu der die zweite Schalteinheit (151) in den Leitungszustand übergeht, und die Zeit, zu der die zweite Schalteinheit (151) in den Nichtleitungszustand übergeht, vorbestimmt sind und eine Zeit, zu der die Schaltsteuereinheit (17) die erste Schalteinheit (16) in den Nichtleitungszustand versetzt, bestimmt wird, in Abhängigkeit von der Zeit, zu der die zweite Schalteinheit (151) in den Leitungszustand übergeht, und
eine Zeit, zu der die Schaltsteuereinheit (17) die erste Schalteinheit (16) in den Leitungszustand versetzt, in Abhängigkeit von der Zeit, zu der die zweite Schalteinheit (151) in den Nichtleitungszustand übergeht, bestimmt wird.

**6.** Detektionsvorrichtung (1) nach Anspruch 1,

wobei in einem elektrischen Weg von der Stromversorgung (13) zu dem Resonanzkreis (RC) ein Untergrenzwert eines elektrischen Widerstands, der notwendig ist, um Dämpfung der Resonanz zu unterdrücken, ein erster elektrischer Widerstand (R1) ist, und
der elektrische Widerstand des elektrischen Wegs von der Stromversorgung zu dem Resonanzkreis in einem Fall, in dem die erste Schalteinheit in dem Leitungszustand ist, ein zweiter elektrischer Widerstand (R2) ist, der kleiner als der erste elektrische Widerstand (R1) ist.

**Revendications**

**1.** Appareil de détection (1) comprenant :

un dispositif d'émission de lumière (10) ;
une unité de réception de lumière (20) qui est configurée pour recevoir de la lumière sur la base d'une irradiation d'un objet cible (T) avec de la lumière émise par le dispositif d'émission de lumière (10) ; et
une unité de détection (30) qui est configurée pour détecter une distance à l'objet cible (T) sur la base de réception de lumière de l'unité de réception de lumière (20), dans lequel le dispositif d'émission de lumière (10) comprend :

un circuit résonant (RC) comprenant un condensateur (14) configuré pour accumuler une charge électrique et générer un courant par résonance se produisant dans le circuit résonant (RC) ;
un élément émetteur de lumière (11) qui est configuré pour émettre de la lumière en réponse à la réception du courant généré par la résonance se produisant dans le circuit résonant (RC) ;
une première unité de commutation (16) qui est connectée à un circuit entre une source d'alimentation (13) qui fournit une charge électrique au condensateur (14) et le circuit résonant (RC) ; et
une deuxième unité de commutation (151) qui est configurée pour commuter entre un état de conduction dans lequel le circuit résonant (RC) est conducteur et un état de non-conduction dans lequel le circuit résonant (RC) n'est pas conducteur, dans lequel la première unité de commutation (16) est configurée pour commuter entre un état de conduction dans lequel un circuit de l'source d'alimentation (13) au circuit résonnant (RC) est conducteur et un état de non-conduction dans lequel le circuit n'est pas conducteur,
dans lequel la première unité de commutation (16) est dans l'état de non-conduction lorsque le condensateur (14) fournit le courant généré par la résonance se produisant dans le circuit résonant (RC) à l'élément émetteur de lumière (11), et
la première unité de commutation (16) est configurée pour être commutée à l'état de conduction après qu'un courant nécessaire à l'émission de lumière de l'élément émetteur de lumière (11) soit fourni du condensateur (14) à l'élément émetteur de lumière (11), et
dans lequel, après que le courant nécessaire à l'émission de lumière de l'élément émetteur de lumière (11) ait été fourni du condensateur (14),
la charge électrique nécessaire à la fourniture d'un courant pour amener l'élément émetteur de lumière (11) à émettre de la lumière est accumulée dans le condensateur (14) pendant une période de temps allant de l'émission de lumière de l'élément émetteur de lumière (11) à la réception de lumière de l'unité de réception de lumière (20),

**caractérisé en ce que** l'appareil de détection (1) est configuré pour définir une distance de 10 m comme une distance à l'objet cible (T) et pour définir la distance à l'objet cible (T) comme une cible de détection,

dans lequel une période de temps allant d'un moment auquel la deuxième unité de commutation (151) passe à l'état de non-conduction à un moment auquel la deuxième unité de commutation (151) passe à l'état de conduction est déterminée conformément à la distance à l'objet cible (T) qui est définie comme la cible de détection dans l'appareil de détection (1).

2. Appareil de détection (1) selon la revendication 1, dans lequel le dispositif d'émission de lumière (10) comprend en outre une unité de contrôle de commutation (17) qui est configurée pour commuter la première unité de commutation (16) à l'état de non-conduction avant que la deuxième unité de commutation (151) ne soit commutée à l'état de conduction dans un cas où la première unité de commutation (16) est dans l'état de conduction et la deuxième unité de commutation (151) est dans l'état de non-conduction.

3. Appareil de détection (1) selon la revendication 1, dans lequel la première unité de commutation (16) est dans l'état de conduction dans un cas où le condensateur (14) ne fournit pas de courant à l'élément émetteur de lumière (11).

4. Appareil de détection (1) selon la revendication 3,

dans lequel le dispositif d'émission de lumière (10) comprend en outre une unité de contrôle de commutation (17) qui est configurée pour commuter la première unité de commutation (16) à l'état de conduction après que la deuxième unité de commutation (151) ait été commutée à l'état de non-conduction dans un cas où la première unité de commutation (16) est dans l'état de non-conduction et la deuxième unité de commutation (151) est dans l'état de conduction.

5. Appareil de détection (1) selon la revendication 1,

dans lequel le dispositif d'émission de lumière (10) comprend en outre une unité de contrôle de commutation (17) qui est configurée pour commuter la première unité de commutation (16) entre l'état de conduction et l'état de non-conduction,

dans lequel le moment auquel la deuxième unité de commutation (151) passe à l'état de conduction et le moment auquel la deuxième unité de commutation (151) passe à l'état de non-conduction sont prédéterminés, et un moment auquel l'unité de contrôle de commutation (17) met la première unité de commutation (16) dans l'état de non-conduction est déterminé,

en fonction du moment auquel la deuxième unité de commutation (151) passe à l'état de conduction, et

un moment auquel l'unité de contrôle de commutation (17) met la première unité de commutation (16) dans l'état de conduction est déterminé, en fonction du moment auquel la deuxième unité de commutation (151) passe à l'état de non-conduction.

6. Appareil de détection (1) selon la revendication 1,

dans lequel dans un chemin électrique allant de l'source d'alimentation (13) au circuit résonant (RC),

une valeur limite inférieure d'une résistance électrique nécessaire pour supprimer une atténuation de la résonance est une première résistance électrique (R1), et une résistance électrique du chemin électrique allant de l'source d'alimentation au circuit résonant dans un cas où la première unité de commutation est dans l'état de conduction est une deuxième résistance électrique (R2) inférieure à la première résistance électrique (R1).

FIG. 1

EP 4 149 211 B1

# FIG. 2

## FIG. 3

TRANSISTOR 151
CONDUCTION STATE

NON-CONDUCTION
STATE

t1

SWITCHING UNIT 16
CONDUCTION STATE

t2          t3

NON-CONDUCTION
STATE

T1 T2        T3 T4                    T5 T6        T7 T8        TIME

EP 4 149 211 B1

# FIG. 4

POWER SUPPLY ~13　　CONTROL UNIT ~17　　SWITCHING UNIT ~16　　CAPACITOR ~14　　LIGHT EMITTING ELEMENT ~11　　TRANSISTOR ~151　　LIGHT RECEIVING UNIT ~20　　DETECTION UNIT ~30

S1. CONDUCTION STATE

S2. SUPPLY CURRENT

S3. LIGHT EMISSION

S4. NON-CONDUCTION STATE

S5. ON

S6. CONDUCTION STATE

S7. SUPPLY ELECTRIC CHARGE

S8. OFF

S9. NON-CONDUCTION STATE

S10. LIGHT RECEPTION

S11. DETECT DISTANCE

S12. CONDUCTION STATE

S13. SUPPLY CURRENT

S14. LIGHT EMISSION

S15. NON-CONDUCTION STATE

S16. ON

S17. CONDUCTION STATE

S18. SUPPLY ELECTRIC CHARGE

S19. OFF

S20. NON-CONDUCTION STATE

S21. LIGHT RECEPTION

S22. DETECT DISTANCE

EP 4 149 211 B1

# FIG. 5

# FIG. 6A

COMPARATIVE EXAMPLE

AMOUNT OF ELECTRIC CHARGE

T11 T12 T13 · · · · T14 T15

t11

t10

TIME

# FIG. 6B

PRESENT EXEMPLARY EMBODIMENT

AMOUNT OF ELECTRIC CHARGE

T21 T22 T23 · · · T24 T25 T26 T27 · · · T28 T29

t14

t13

t12

TIME

**EP 4 149 211 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020188239 A
- JP 2009260030 A
- US 2021021098 A1
- US 2017276771 A1
- US 2017070029 A1